# EUROPEAN PATENT APPLICATION

(11) **EP 2 034 571 A2**
(43) Date of publication of application: **11.03.2009**
(21) Application number: 08015639.1
(22) Date of filing: 04.09.2008
(51) Int. Cl.: H01S 5/06, H01S 5/10, H01S 5/026

(54) **Wavelength tunable light source, control method and control program therof, and optical module**

(30) Priority: 05.09.2007 JP 2007230593
(71) Applicant: NEC Corporation, Minato-ku Tokyo 108-8001 (JP)
(72) Inventor: Suzuki, Kouichi, Minato-ku Tokyo (JP)
(74) Representative: Glawe, Delfs, Moll

(57) **Abstract**

To improve optical power detection accuracy without increasing size, etc. of a device, when controlling a plurality of light variable parts such that the sum of a plurality of optical powers becomes the minimum. Provided is a wavelength tunable light source (10) for changing the wavelength of light by using a multiple resonator (20) including two or more coupled resonators (21,22,23) with different optical path lengths from each other. The light source (10) includes: a single or more light variable parts (22h,23h) for changing transmittance of the resonators (22,23); photosensor parts (21p,22p,23p) which detect each light outputted from the two or more resonators (21,22,23) by each of the resonators as optical powers being converted into electric power values; and a control unit (18) which adds the optical powers detected by the photosensor parts (21p,22p,23p) by each resonator, and controls changes in the transmittance by the light variable parts such that the sum of the added optical powers becomes the minimum.

## Description

### CROSS-REFERENCE TO RELATED APPLICATION

This application is based upon and claims the benefit of priority from Japanese patent application No. 2007-230593, filed on September 5, 2007, the disclosure of which is incorporated herein in its entirety by reference.

### BACKGROUND OF THE INVENTION

### 1. Field of the Invention

The present invention relates to a wavelength tunable light source and the like capable of changing wavelengths of light by using a multiple resonator, which can be used for a transmission system and the like such as WDM (Wavelength Division Multiplexing).

### 2. Description of the Related Art

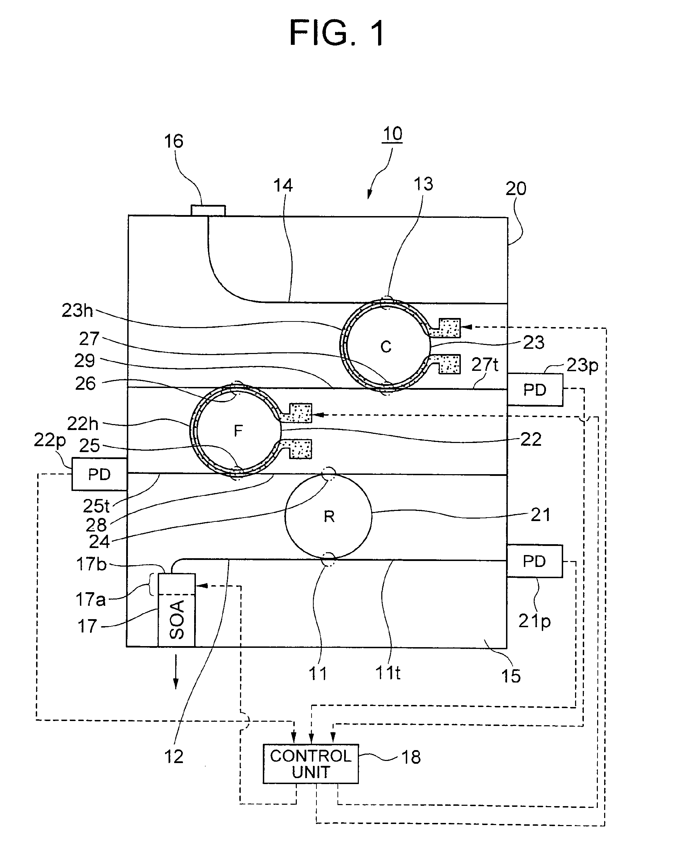

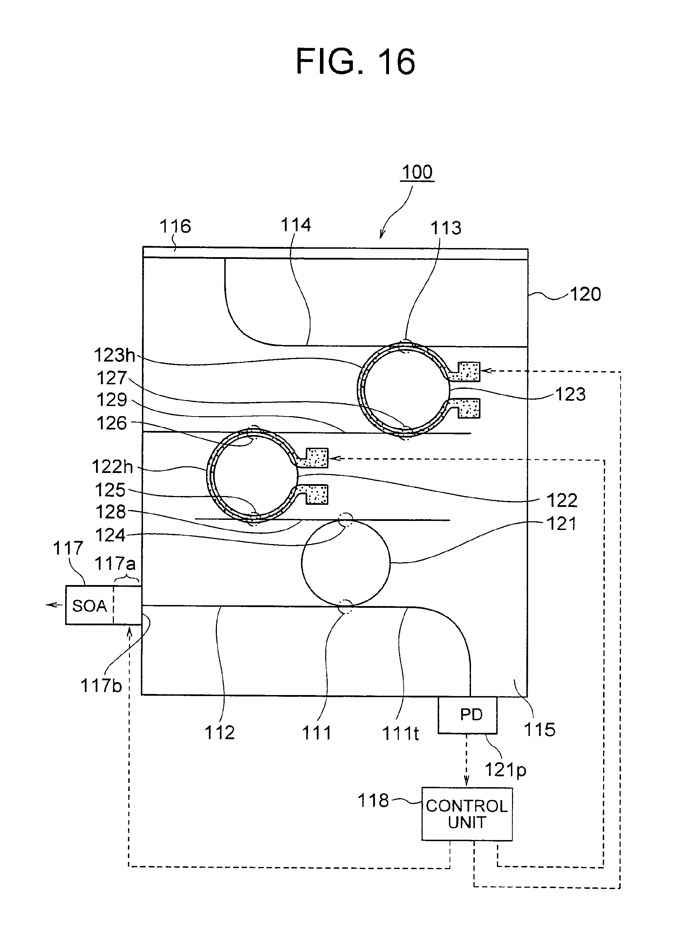

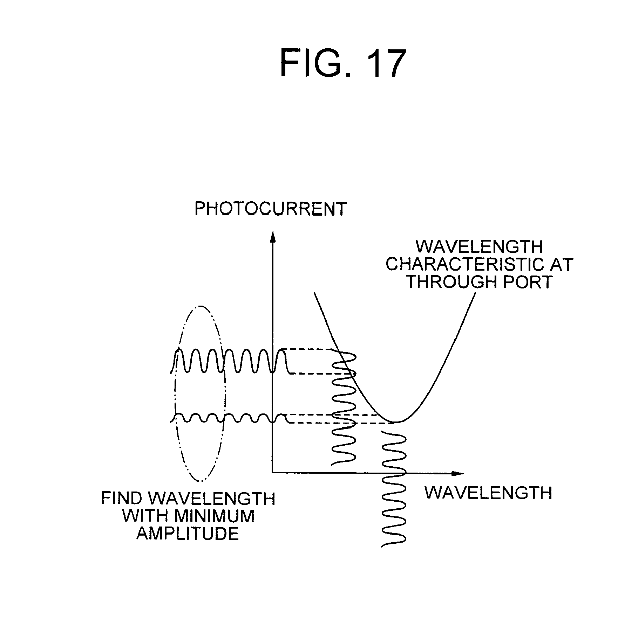

FIG. 16 is a plan view showing a wavelength tunable light source disclosed in Patent Document 1 (Japanese Unexamined Patent Publication 2006-245346 (FIG. 1, FIG. 6, FIG. 13, etc.): a part thereof is illustrated as a block diagram). FIG. 17 is a graph showing a control method for changing the wavelength of the wavelength tunable light source that is shown in FIG. 16. Explanations will be provided hereinafter by referring to those drawings.

A multiple ring resonator 120 includes: ring resonators 121 - 123 each configured with a ring-type waveguide that has a different optical path length from each other, which are connected via directional couplers 124 - 127 and waveguides 128, 129; an input/output side waveguide 112 whose one end is connected to the ring resonator 121 via a directional coupler 111; a reflection side waveguide 114 whose one end is connected to the ring resonator 123 via a directional coupler 113; a PLC (Planner Lightwave Circuit) board 115 on which the ring resonators 121 - 123, the input/output side waveguide 112, and the reflection side waveguide 114 are formed; and a high reflection film 116 that is provided to the other end of the reflection side waveguide 114.

A wavelength tunable light source 100 includes: the multiple ring resonator 120; an SOA (Semiconductor Optical Amplifier) 117 whose light input/output end 117b is connected to the other end of the input/output side waveguide 112; film-like heaters 122h and 123h for changing the resonance wavelength of the multiple ring resonator 120; a light-receiving element 121p which detects the resonance wavelength of the multiple ring resonator 120 at a through port 111t of the directional coupler 111; and a control unit 118 for controlling powers supplied to the heaters 122h and 123h based on the optical power detected at the light receiving element 121p. The control unit 118 also has a function of controlling the wavelength by controlling an amount of electric powers flown to a phase control area 117a.

The resonance wavelength in the multiple ring resonator 120, i.e., the wavelength with matching cycles, varies largely depending on circumference lengths of each of the rings resonators 121 - 123 and changes in the waveguide refractive indexes. This waveguide refractive index can be changed by a thermo optic effect. That is, it is possible to change the resonance wavelength of the multiple ring resonator 120 through controlling the powers supplied to the heaters 122h and 123h by utilizing the temperature property of the ring resonators 122 and 123. As described, in the wavelength tunable light source 100, the multiple ring resonator 120 is configured by connecting three ring resonators 121 - 123 each having slightly difference circumference in series so as to utilize a vernier effect generated thereby.

Further, when the resonance wavelength is obtained in the multiple ring resonator 120, the optical power detected at the light-receiving element 121p becomes the minimum. Thus, as shown in FIG. 17, the control unit 118 changes the wavelength in a sine wave form by controlling the powers supplied to the heaters 122h and 123h, and finds the wavelength with which the amplitude of photocurrents obtained at the light-receiving element 121p in that state becomes the minimum. This wavelength is the resonance wavelength to be obtained, as can be seen from FIG. 17.

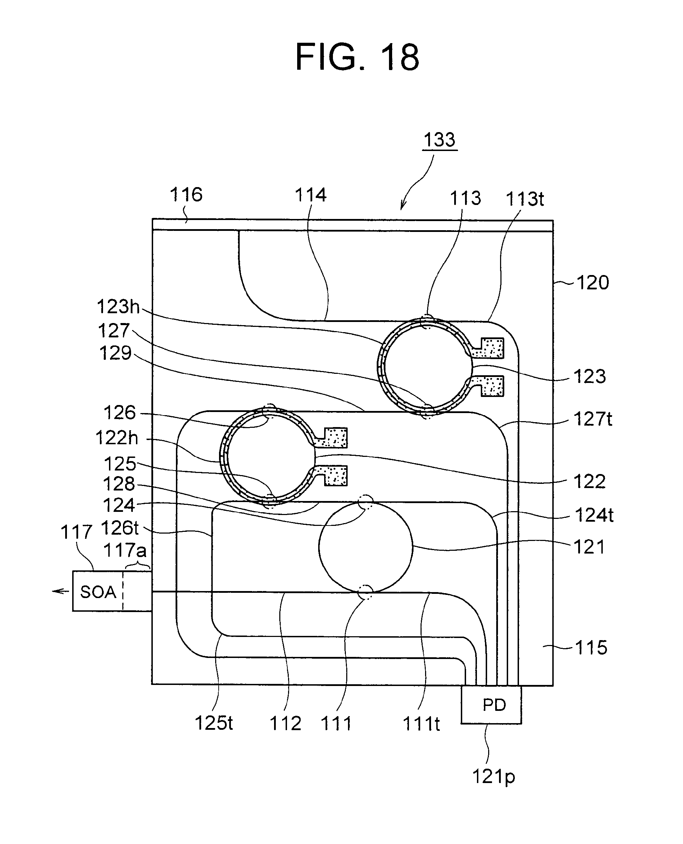

FIG. 18 is a plan view showing another wavelength tunable light source disclosed in Patent Document 1. Explanations will be provided hereinafter by referring to this drawing. Same reference numerals are applied to the components that are the same as those of FIG. 16, and explanations thereof will be omitted.

In this wavelength tunable light source 133, a light-receiving element 121p is configured to guide light from all the through ports. That is, the light-receiving element 121p detects a sum of: light passing through a through port 111t of a directional coupler 111 that couples a ring resonator 121 to an input/output side waveguide 112; light passing through a through port 124t of a directional coupler 124 that couples the ring resonator 121 and a waveguide 128; light passing through a through port 126t of a directional coupler 126 that couples a ring resonator 122 and a waveguide 129; light passing through a through port 125t of a directional coupler 125 that couples the ring resonator 122 and a waveguide 124; light passing through a through port 113t of a directional coupler 113 that couples a sing resonator 123 to a reflection side waveguide 114; and light passing through a through port 127t of a directional coupler 127 that couples the ring resonator 123 to the waveguide 129. In this case, the powers supplied to the heaters 122h and 123h are also controlled such that the optical power detected at the light-receiving element 121p becomes the minimum. As described, Patent Document 1 discloses a technique which optically adds up the light outputted from the through ports of the ring resonators 121- 123 to irradiate the add-up light to the single light-receiving element 121p.

However, the wavelength tunable light sources disclosed in Patent Document 1 have following issues.

In the wavelength tunable light source 100 shown in FIG. 16, only the light outputted from the through port 111t of the ring resonator 121 is irradiated to the single light-receiving element 121p. In this case, it is found as a result of an experiment that the power value supplied to the heaters 122h and 123h to minimize the amplitude of the photocurrents of the light-receiving element 121p becomes shifted slightly from the power value supplied to the heaters 122h and 123h to maximize the light outputted from the SOA 117. Thus, it is difficult to maximize the output light of the SOA 117 if the powers supplied to the heaters 122h and 123h are controlled to minimize the amplitude of the photocurrents of the light-receiving element 121p.

In the meantime, in the wavelength tunable light source 133 shown in FIG. 18, the light outputted from the through ports 111t, --- of the ring resonators 121 - 123 is optically added optically to be irradiated to the single light-receiving element 121p. In this case, it is found as a result of an experiment that the power value supplied to the heaters 122h and 123h to minimize the amplitude of the photocurrents of the light-receiving element 121p is consistent with the power value supplied to the heaters 122h and 123h to maximize the output light of the SOA 117. However, interference fringes are generated when optically adding up the light outputted from the through ports 111t, --- of the ring resonators 121 - 123. This generate variations in distribution of light on the light-receiving face of the light-receiving element 121p, thereby deteriorating the precision of the photocurrents. Use of light-receiving elements having a larger light-receiving face for reducing the influences of such interference fringes generates other issues such as an increase in the size of the device and an increase in the price thereof.

### SUMMARY OF THE INVENTION

It is therefore an exemplary object of the present invention to provide a wavelength tunable light source and the like, which can improve the detection accuracy of the optical powers without increasing the size of the device, etc., when controlling a plurality of light variable parts to minimize the sum of a plurality of optical powers.

A wavelength tunable light source according to an exemplary aspect of the invention is a wavelength tunable light source for changing a wavelength of light by using a multiple resonator including two or more coupled resonators with different optical path lengths from each other. The wavelength tunable light source includes: a single or more light variable part for changing transmittance of the resonators; photosensor parts which detect each light outputted from the two or more resonators by each of the resonators as optical powers being converted into electric power values; and a control unit which adds the optical powers detected by the photosensor parts by each of the resonators, and controls changes in the transmittance by the light variable part such that sum of the added optical powers becomes minimum.

An optical module according to another exemplary aspect of the invention includes: a wavelength tunable light source for changing a wavelength of light by using a multiple resonator including two or more coupled resonators with different optical path lengths from each other; a temperature regulating part for keeping a temperature of the wavelength tunable light source except for a control unit; a case for housing the temperature regulating part and the wavelength tunable light source except for the control unit; an electricity conducting part which supplies electric powers to the temperature regulating part and the wavelength tunable light source except for the control unit from outside of the case, and inputs/outputs an electric signal; and a light conduction part for guiding light emitted from the wavelength tunable light source to the outside the case. The wavelength tunable light source includes: a single or more light variable part for changing transmittance of the resonators; photosensor parts which detect each light outputted from the two or more resonators by each of the resonators as optical powers being converted into electric power values; and the control unit which adds the optical powers detected by the photosensor parts by each of the resonators, and controls changes in the transmittance by the light variable part such that sum of the added optical powers becomes minimum.

A control method of a wavelength tunable light source according to still another exemplary aspect of the invention is a control method that changes a wavelength of light by using a multiple resonator including two or more coupled resonators with different optical path lengths from each other. The method includes: detecting each light outputted from the two or more resonators by each of the resonators as optical powers that are being converted into electric power values; and adding the optical powers detected by each of the resonators, and changing transmittance of the resonators by a plurality of light variable parts individually such that sum of the added optical powers becomes minimum.

A control program for a wavelength tunable light source according to still another exemplary aspect of the invention is a control program for a wavelength tunable light source that changes a wavelength of light by using a multiple resonator including two or more coupled resonators with different optical path lengths from each other. The program enables a computer to execute a function of adding optical powers that are detected by converting light outputted respectively from the two or more resonators into electric power values, and changing transmittance of the resonators by a plurality of light variable parts individually such that sum of the added optical powers becomes minimum.

### BRIEF DESCRIPTION OF THE DRAWINGS

FIG. 1 is a plan view showing a first exemplary embodiment of a wavelength tunable light source according to the present invention (a part thereof is shown as a block diagram);
FIG. 2 is a graph showing a relation between oscillation wavelengths of a multiple ring resonator in the wavelength tunable light source shown in FIG. 1 and powers supplied to each heater;
FIG. 3 is a first graph showing a relation between the powers supplied to each heater of the wavelength tunable light source shown in FIG. 1 and optical powers at a light-receiving element;
FIG. 4 is a second graph showing the relation between the powers supplied to each heater of the wavelength tunable light source shown in FIG. 1 and the optical powers at the light-receiving element;
FIG. 5 is a first graph showing a relation between shift of the powers supplied to each heater of the wavelength tunable light source shown in FIG. 1 from an optimum value and the optical powers at the light-receiving element;
FIG. 6 is a second graph showing a relation between shift of the powers supplied to each heater of the wavelength tunable light source shown in FIG. 1 from the optimum value and the optical powers at the light-receiving element;
FIG. 7 is a block diagram showing an example of a hardware structure of a control unit in the wavelength tunable light source shown in FIG. 1;
FIG. 8 is a block diagram showing an example of a functional structure of the control unit in the wavelength tunable light source shown in FIG. 1;
FIG. 9 is an illustration for describing a part of operations of a plural-combinations making device shown in FIG. 8;
FIG. 10 is an illustration for describing a part of operations of a re-convergence judging device shown in FIG. 8;
FIG. 11 is a flowchart showing an example of a wavelength switching operation performed by the control unit shown in FIG. 8;
FIG. 12 is a flowchart showing an example of a steady-state operation performed by the control unit shown in FIG. 8;
FIG. 13 is a flowchart showing an example of a re-convergence operation performed by the control unit shown in FIG. 8;
FIG. 14 is a block diagram showing a second exemplary embodiment of the wavelength tunable light source according to the present invention;
FIGS. 15A and 15B show a first exemplary embodiment of an optical module according to the present invention, in which FIG. 15A is a plan view and FIG. 15B is a fragmentary side view;
FIG. 16 is a plan view showing a wavelength tunable light source disclosed in Patent Document 1(a part thereof is shown as a block diagram);
FIG. 17 is a graph showing a control method for changing the wavelength in the wavelength tunable light source shown in FIG. 16; and
FIG. 18 is a plan view showing another wavelength tunable light source disclosed in Patent Document 1.

### DETAILED DESCRIPTION OF THE EXEMPLARY EMBODIMENTS

FIG. 1 is a plan view showing a first exemplary embodiment of a wavelength tunable light source according to the present invention (a part thereof is shown as a block diagram). Explanations will be provided hereinafter by referring to this drawing.

A wavelength tunable light source 10 according to this exemplary embodiment includes: a multiple ring resonator 20 including coupled ring resonators 21, 22, 23 which have different optical path lengths from each other; light-receiving elements 21p, 22p, 23p as photosensor parts for detecting optical powers outputted from the ring resonators 21, 22, 23 via through ports 11t, 25t, 27t; film-like heaters 22h, 23h as a plurality of light variable parts which individually work on the ring resonators 22 and 23 to change the transmittance of the multiple ring resonator 20; an SOA 17 as a light input/output part which supplies light to the multiple ring resonator 20 and emits the light returned from the multiple ring resonator 20 to the outside; and a control unit 18 for controlling the heaters 22h and 23h according to the optical powers detected at the light-receiving elements 21p - 23p.

The light-receiving elements 21p, 22p, and 23p are provided at the through ports 11t, 25t, and 27t of the ring resonators 21, 22, and 23, respectively. The control unit 18 has a function of controlling the heaters 22h and 23h such that the sum of the optical powers detected at the light-receiving elements 21p - 23p becomes the minimum. The light-receiving elements 21p - 23p output electric signals in accordance with the powers of the light irradiated to the light-receiving faces. The sum of the electric signals outputted from the light-receiving elements 21p - 23p may be obtained in an analog way by an operational amplifier circuit or the like, or may be obtained in a digital way by an A/D converter and a microcomputer as will be described later.

Each of the ring resonators 21 - 23 is configured with a ring-type waveguide having different optical path length from each other, and the resonators are coupled to each other via directional couplers 24 - 27 and waveguides 28, 29. The multiple ring resonator 20, in addition to the ring resonators 21 - 23, includes: an input/output side waveguide 12 whose one end is connected to the ring resonator 21 via a directional coupler 11; a reflection side waveguide 14 whose one end is connected to the ring resonator 23 via a directional coupler 13; a PLC board 15 on which the ring resonators 21 - 23, the input/output side waveguide 12, and the reflection side waveguide 14 are formed; and a high reflection film 16 provided to the other end of the reflection side waveguide 14.

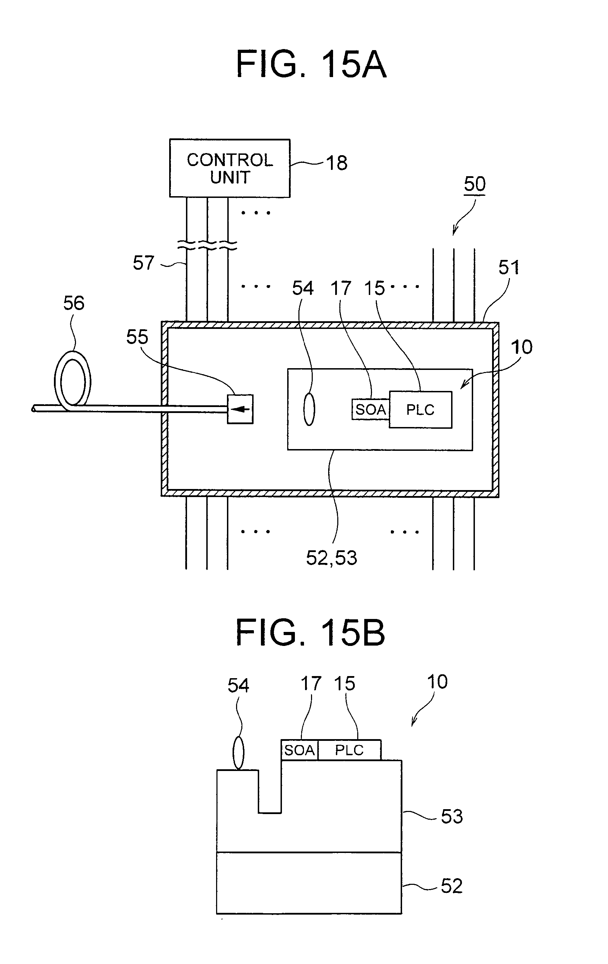

The ring resonators 21 - 23 are formed by a PLC technique, for example, and various kinds of waveguides such as the ring-type waveguides are configured with a quartz-based glass waveguide that is formed by depositing quartz-based glass on a silicon substrate or a glass substrate, a ferroelectric-type waveguide that is formed by making a ferroelectric material (lithium niobate or the like) into a thin film, or the like, for example. The heaters 22h and 23h are arc-form aluminum films formed on the ring resonators 22 and 23, for example, and both ends of the arcs are electrodes for letting through the electric power. In other words, the heaters 22h and 23h can be formed on the PLC board 15 by vapor-depositing or attaching a metal film, for example, and aluminum, platinum, chrome, or the like is used as a material thereof. The heaters 22h and 23h may be formed as a thin film or thick film. The SOA 17 has a phase control area 17a, and a light input/output end 17b is connected to the other end of the input/output side waveguide 12. Such SOA 17 is of a typical one, so that explanations of the structure and the operation principle thereof are omitted. Photodiodes are used for the light-receiving elements 21p - 23p. Further, the PCL board 15 is provided on a Peltier element 52 as a temperature regulator (FIG. 15). This Peltier element 15 keeps the temperature of the PLC board 15 to be constant so that FSR (Free Spectral Range) of the ring resonator 21 matches with ITU (International Telecommunication Union) grid. The SOA 17 is coupled to the other end of the input/output side waveguide 12 via a reflection-free film (not shown). The high reflection film 16 is formed by vapor-depositing or pasting a dielectric multilayer film on a side face of the PLC board 15, for example. A loop mirror or the like configured with a waveguide may also be used instead of the high reflection film 16.

Next, operations of the wavelength tunable light source 10 will be described. The light emitted from the SOA 17 returns through a route of the SOA 17 → the input/output side waveguide 12 → the directional coupler 11 → the multiple ring resonator 20 → the directional coupler 13 → the reflection side waveguide 14 → the high reflection film 16 → the reflection side waveguide 14 → the directional coupler 13 → the multiple ring resonator 20 → the directional coupler 11→ the input/output side waveguide 12 → the SOA 17. This return light comes to have the highest intensity with the resonance wavelength of the multiple ring resonator 20. It is because each FSR of the ring resonators 21 - 23 configuring the multiple ring resonator 20 is slightly different from each other, so that a still larger reflection is generated with the wavelength (resonance wavelength) with which periodical changes in the reflection (transmission) generated in each of the ring resonators 21 - 23 are consistent. Further, the light passing through the through ports 11t, 25t, and 26t of the directional couplers 11, 25, and 26 becomes the minimum with the resonance wavelength of the multiple ring resonator 20. Therefore, it is possible to detect the resonance wavelength of the multiple ring resonator 20 by detecting the light amount in the through ports 11t, 25t, and 26t by the light-receiving elements 21p - 23p.

In the meantime, the resonance wavelength, i.e., the wavelength with matching cycles, changes largely depending on circumference lengths of each of the rings resonators 21 - 23 and changes in the waveguide refractive indexes. This waveguide refractive index can be changed by the thermo optic effect. That is, it is possible to change the resonance wavelength of the multiple ring resonator 20 through controlling the powers supplied to the heaters 22h and 23h by utilizing the temperature property of the ring resonators 22 and 23. As described, in this exemplary embodiment, the multiple ring resonator 20 is configured by connecting three ring resonators 21 - 23 each having slightly different circumference in series, and a vernier effect generated thereby is utilized in a clever manner.

When the circumference lengths (i.e., the optical paths lengths) of the ring resonators 21 - 23 are set as 4,000 µm, 4,400 µm, and 4,040 µm, respectively, the heater 22h operates as a fine-adjustment light variable part and the heater 23h operates as a coarse-adjustment light variable part. In FIG. 1, "R(Reference)", is applied to the center of the reference ring resonator 21, "F(Fine)" is applied to the center of the fine-adjustment ring resonator 22, and "C(Coarse)" is applied to the center of the coarse-adjustment ring resonator 23.

The control unit 18 is configured mainly with a micro computer such as a DSP and its program, and it controls the supply of power to the heaters 22h and 23h such that the sum of the optical powers detected at the light-receiving elements 21p - 23p becomes the minimum, i.e., desired resonance wavelengths become constant. The control unit 18 also has a function of controlling the wavelength by controlling the amount of electric powers supplied to the phase control area 17a. For example, a wavelength control about several ten pm is executed by supplying an electric current to the phase control area 17a of the SOA 17.

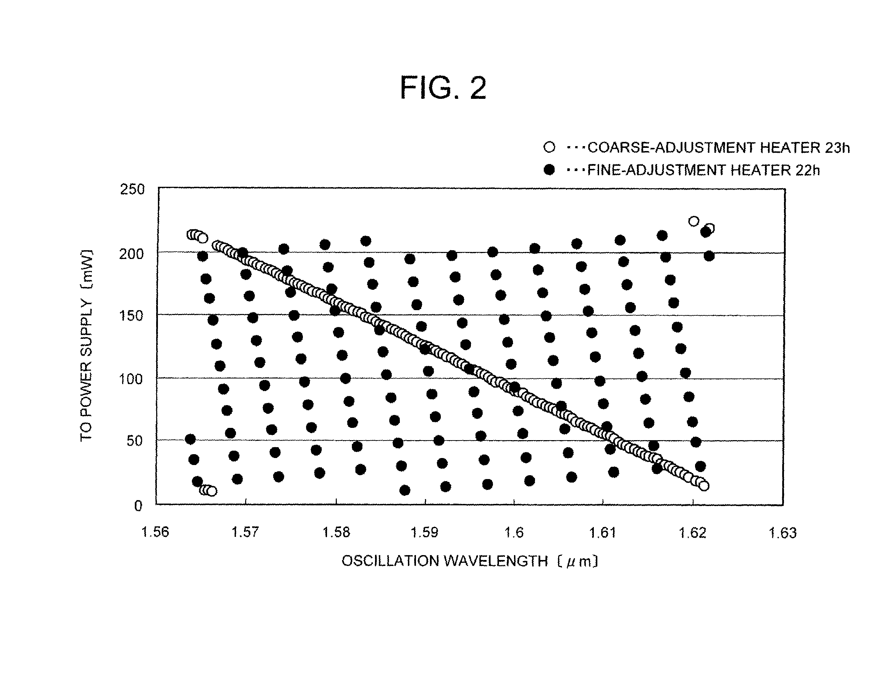

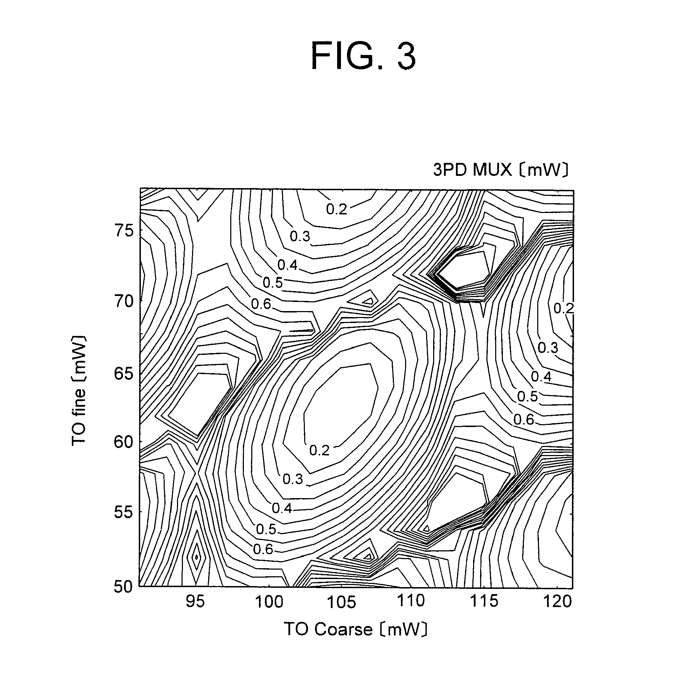

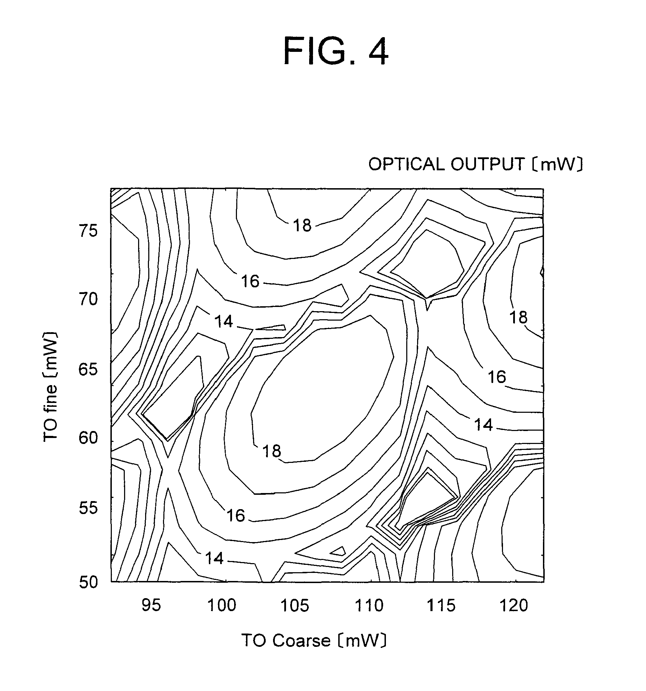

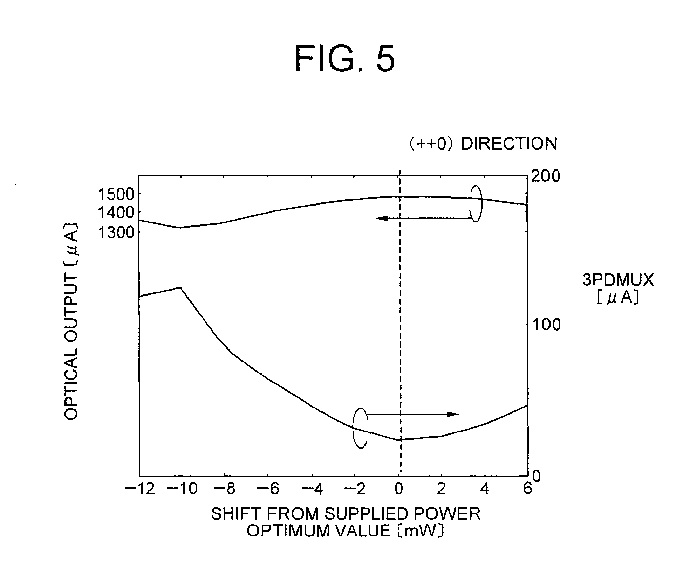

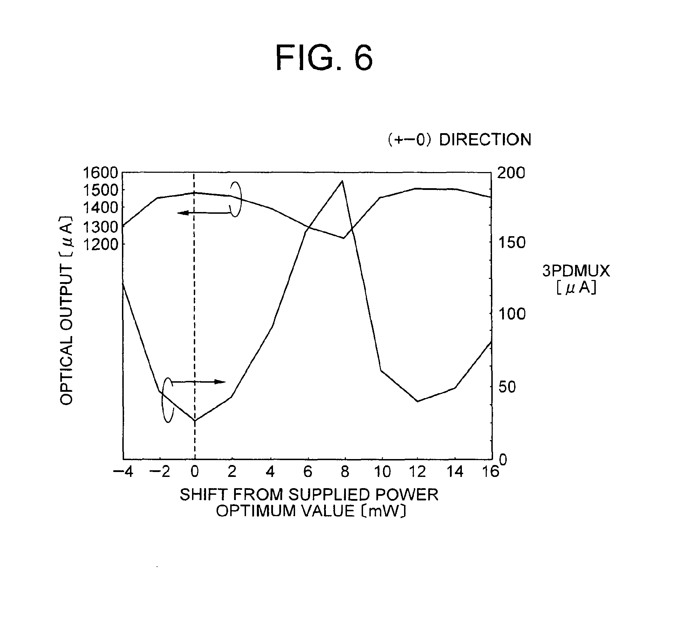

FIG. 2 is a graph showing a relation between oscillation wavelengths of the multiple ring resonator and powers supplied to each heater. FIG. 3 and FIG. 4 are graphs showing relations between the powers supplied to each heater and optical powers at the light-receiving element. FIG. 5 and FIG. 6 are graphs showing relations between shift of the powers supplied to each heater from an optimum value and the optical powers at the light-receiving element. Explanations will be provided hereinafter by referring to FIG. 1 - FIG. 6.

Data shown in FIG. 2 - FIG. 6 is the data under a state where the sum of the photocurrents in the light-receiving elements 21p - 23p are set to be the minimum through controlling the amount of electric current flown to the phase control area 17a by fixing the power supplied to the heaters 23h and 22h to the values shown at each axis. The method shown in FIG. 17 described above may be used to control the amount of electric current flown to the phase control area 17a, for example.

FIG. 2 shows an example of the relation between the oscillation wavelengths of the wavelength tunable light source 10 immediately after manufacture and powers supplied to the heaters 23h, 22h. The horizontal axis shows the oscillation wavelengths, and the vertical axis shows the supplied powers. The powers supplied to the coarse-adjustment heater 23h are shown with white circles (o), and the powers supplied to the fine-adjustment heater 22h are shown with black circles (•). That is, FIG. 2 shows the results obtained when the power supplied to either the coarse-adjustment heater 23h or the fine-adjustment heater 22h is fixed, and the power supplied to the other is changed. Naturally, the change in the resonance wavelength for the same supplied power is large with the coarse-adjustment heater 23h, while it is small with the fine-adjustment heater 22h.

As can be seen from this graph, each wavelength channel is arranged at about 18 mW intervals. A shift amount tolerated for the powers supplied to the heaters 23h and 22h is only about 2 mW. Thus, it is necessary to correct the shift from the optimum supplied power condition generated due to various factors, through determining the supplied power condition efficiently.

FIG. 3 and FIG. 4 are graphs showing the relations between the powers supplied to each of the heater 22h, 23h and optical powers at the light-receiving element, i.e., the graphs showing TO (Thermo Optics Effect) tolerance characteristic of a given wavelength of the wavelength tunable light source 10, and the center of the graph is the most stable supplied power condition. FIG. 3 shows total values (referred to as "3PDMUX" hereinafter) of the light that is outputted from the through ports 11t, 25t, 27t of the ring resonators 21, 22, 23 and converted to electric current values at the light-receiving elements 21p, 22p, 23p.

FIG. 4 shows values (referred to as "optical output" hereinafter) that are the electric power values obtained through converting, by the light-receiving elements (not shown), the light outputted from the SOA 17 to the outside the wavelength tunable light source 10. In FIG. 3 and FIG. 4, the power supplied to the coarse-adjustment heater 23h is expressed as "TOcoarse", and the power supplied to the fine-adjustment heater 22h is expressed as "TOfine" (the same applies hereinafter). That is, FIG. 3 and FIG. 4 show the results obtained when the coarse-adjustment heater 23h and the fine-adjustment heater 22h are controlled simultaneously.

As can be seen from the graphs, the maximum point of the optical output and the minimum point of the 3PDMUX are consistent with each other completely, and the shapes of curves (protruded parts and recessed parts) are inverted from each other. Physically, the fact that the 3PDMUX is small means that a loss in an optical filter of the PLC, i.e., the loss at the multiple ring resonator 20, is small. Thus, when the 3PDMUX becomes the minimum, the optical output becomes the maximum as well. Therefore, the two optimum points match with each other. The supplied power condition is optimized by utilizing this property.

FIG. 5 and FIG. 6 show the relations between the shift of the powers supplied to each heater from the optimum value and the 3PDMUX, i.e., the results obtained by comparing the tolerances regarding the optical output and the 3PDMUX for the supplied powers. The optimum values of the supplied powers are the values at "0" of the lateral axes in FIG. 5 and FIG. 6. " (++0) " direction shown in FIG. 5 indicates an operation which increases/decreases the wavelengths of the ring resonators 22, 23 by a same amount, and does not change the wavelength of the ring resonator 21. "(+-0)" direction shown in FIG. 6 indicates an operation which changes the wavelengths of the ring resonators 22, 23 inversely, and does not change the wavelength of the ring resonator 21.

As can be seen from the graphs, with the optical output curving (protruded) in the upward direction, a fluctuation ratio with respect to the supplied power is small in both the (++0) direction and the (+-)direction. Thus, the sensitivity when the supplied power is shifted becomes small as well. In the meantime, the fluctuation ratio with respect to the supplied power is large in the 3PDMUX that is curving (protruded) in the downward direction. Thus, the sensitivity when the supplied power is shifted becomes large. Therefore, the 3PDMUX is preferable as a control system. In particular, there are cases where the fluctuation ratio of the optical output exhibits almost no change depending on oscillation conditions, so that the 3PDMUX that can obtain a large sensitivity irrespective of the oscillation conditions is preferable for optimizing the supplied power.

With the wavelength tunable light source 10 of this exemplary embodiment, the light-receiving elements 21p, 22p, 23p are provided at the through ports 11t, 25t, 27t, respectively, for obtaining the sum of the optical powers detected at the light-receiving elements 21p, 22p, 23p so as to obtain the sum of the optical powers not optically but electrically, when controlling the heaters 22h, 23h in such a manner that the sum of the optical powers outputted from the through ports 11t, 25t, 27t of the ring resonators 21 - 23 becomes the minimum. Therefore, it is possible to prevent deterioration in the detection accuracy of the optical powers caused due to interference fringes. As a result, the detection accuracy of the optical powers can be improved without increasing the size and the like of the device.

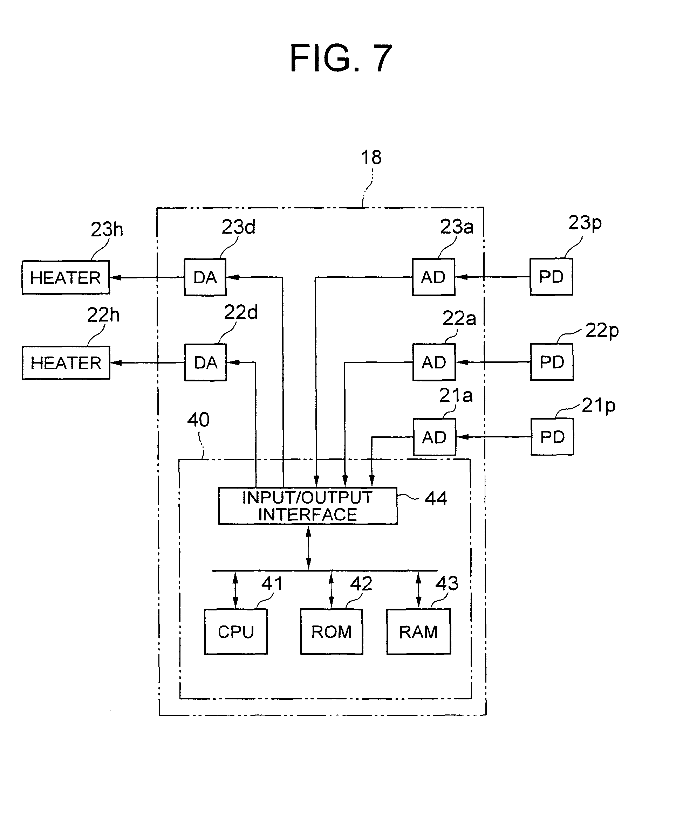

FIG. 7 is a block diagram showing an example of a hardware structure of the control unit of the wavelength tunable light source shown in FIG. 1. Explanations will be provided hereinafter by referring to this drawing.

The control unit 18 is configured mainly with a micro computer 40, as well as A/D converters 21a, 22a, 23a, D/A converters 22d, 23d, and the like. The A/D converters 21a - 23a convert analog signals outputted from the light-receiving elements 21p - 23p into digital signals, and output those to the micro computer 40. The D/A converters 22d, 23d also work as drivers of the heaters 23h, 22h, which supply powers (analog signals) to the heaters 23h, 22h in accordance with control signals (digital signals) from the micro computer 40. The micro computer 40 is a typical one such as a DSP, and a CPU 41 takes out instructions of a program stored in a RAM 43 one by one, and decodes and executes each instruction. The micro computer 40 includes the CPU 41, a ROM 42, the RAM 43, and an input/output interface 44, and the like. The input/output interface 44 also has a function of allowing communicating between the CPU 41 and external computers and the like. The sum of the photocurrents as the electric signals outputted from the light-receiving elements 21p - 23p is obtained in a digital way by the A/D converters 21a - 23a and the micro computer 40. Although not shown, the control unit 18 also has a function of controlling the phase control area 17a (FIG. 1) and the Peltier element 52 (FIG. 15).

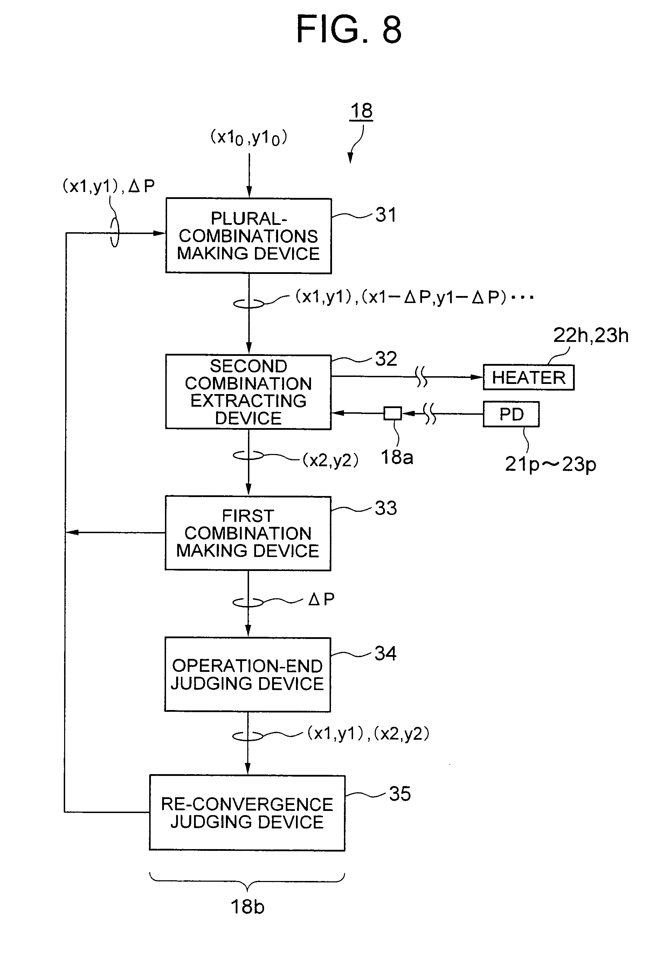

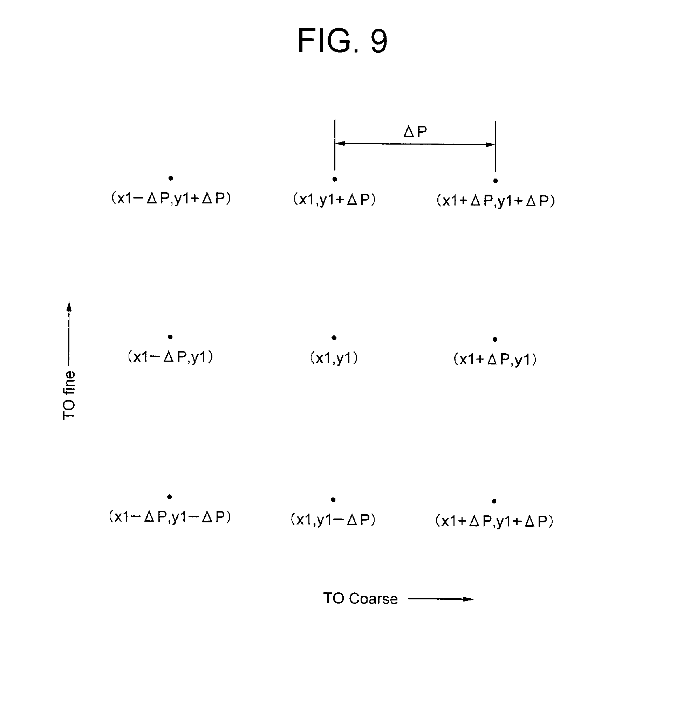

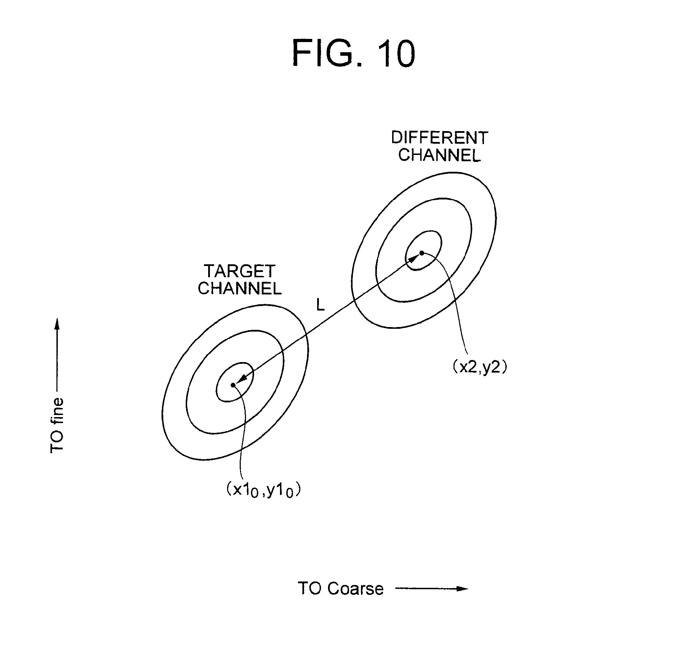

FIG. 8 is a block diagram showing an example of a functional structure of the control unit in the wavelength tunable light source shown in FIG. 1. FIG. 9 is an illustration for describing a part of operations of a plural-combinations making device shown in FIG. 8. FIG. 10 is an illustration for describing a part of operations of a re-convergence judging device shown in FIG. 8. Explanations will be provided hereinafter by referring to FIG. 1, and FIG. 8 - FIG. 10.

The control unit 18 includes: an optical power adding device 18a for obtaining the sum of the optical powers detected at the light-receiving elements 21p - 23p; and a light variable part control device 18b for controlling the heaters 22h, 23h such that the sum of the optical powers obtained by the optical power adding device 18a becomes the minimum. The light variable part control device 18b includes a plural-combinations making device 31, a second combination extracting device 32, a first combination making device 33, an operation-end judging device 34, a re-convergence judging device 35, and the like.

The plural-combinations making device 31 makes a plurality of combinations by changing at least one control input value, regarding the first combination of values of each control input for the plurality of light variable parts. The second combination extracting device 32 controls the plurality of light variable parts according to the plurality of combinations and the first combination, and takes the combination with which the sum of the optical powers detected at the photosensor parts becomes the minimum as the second combination. The first combination making device 33 brings the values of each control input of the first combination closer to the values of each control input of the second combination to make a new first combination, and outputs it to the plural-combinations making device 31.

As shown in FIG. 1, it is assumed here that the plurality of ring resonators are the ring resonators 21, 22, 23, the photosensor parts are the light-receiving elements 21p, 22p, 23p provided at each of the through ports 11t, 25, 27t of the ring resonators 21, 22, 23, the plurality of light variable parts are the heater 22h provided to the ring resonator 22 and the heater 23h provided to the ring resonator 23. In this case, the plural-combinations making device 31 has a function of making a plurality of combinations by changing at least one value of the supplied power, regarding the first combination of the values of each power supplied to the heaters 22h, 23h. The second combination extracting device 32 has a function of controlling the heaters 22h, 23h according to the plurality of combinations and the first combination, and taking the combination with which the sum of the optical powers detected at the light-receiving elements 21p - 23p becomes the minimum as the second combination. The first combination making device 33 has a function of bringing the values of each supplied power of the first combination closer to the values of each supplied power of the second combination to make a new first combination, and outputting it to the plural-combinations making device 31.

Each of the devices in this case may further be embodied as follows.

As shown in FIG. 9, the plural-combinations making device 31 has a function of making eight kinds of combinations by increasing/decreasing the values in the first combination (x1, y1) that is the combination of the values supplied to each of the heaters 23h, 22h by power amplitude "ΔP". The eight combinations are (x1-ΔP, y1-ΔP), (x1-ΔP, y1), (x1-ΔP, y1+ΔP), (x1, y1+ΔP), (x1+ΔP, y1+ΔP), (x1+ΔP, y1), (x1+ΔP, y1-ΔP), and (x1, y1-ΔP). The second combination extracting device 32 has a function of controlling the heaters 22h, 23h according to the eight kinds of combinations and the first combination, and taking the combination with which the sum of the optical powers detected at the light-receiving elements 21p - 23p becomes the minimum as the second combination(x2, y2). The first combination making device 33 has a wavelength switching function which takes half values of the sum of the values of each supplied power of the second combination and the values of each supplied power of the first combination, "((x1+x2)/2, (y1+y2)/2) ", as a new first combination, takes a half the value of the power amplitude ΔP, "ΔP/2", as a new power amplitude, and outputs the new first combination and the new power amplitude to the plural-combinations making device 31. The operation-end judging device 34 has a wavelength switching function which ends the operations of the plural-combinations making device 31, the second combination extracting device 32, and the first combination making device 33, when the new power amplitude becomes a specific value or smaller. Further, the initial values of the first combination (x1, y1) are set in advance as the values corresponding to the resonance wavelength of the multiple ring resonator 20.

Further, after the operations of the plural-combinations making device 31, the second combination extracting device 32, and the first combination making device 33 are ended by the operation-end judging device 34, the re-convergence judging device 35 takes "(x1₀-Δp{(x2-x1₀)/L}, y1₀-Δp{(y2-y1₀)/L})" as a new first combination, the initial value of the power amplitude ΔP as a new power amplitude, and outputs the new first combination and the new power amplitude to the plural-combinations making device 31, when a difference L = √{x2-x1₀}²+(y2-y1₀)²} between the values of each supplied power of the second combination and the initial values of each supplied power of the first combination becomes a specific value or larger provided that the initial values of the first combination (x1, y1) are (x1₀, y1₀) and a power value smaller than the initial value of the power amplitude ΔP is Δp, as shown in FIG. 10.

Further, in addition to the wavelength switching function described above, the first combination making device 34 has a steady-state function which takes half values of the sum of the values of each supplied power of the second combination and the values of each supplied power of the first combination, "((x1+x2)/2, (y1+y2)/2)", as a new first combination, and outputs the new first combination to the plural combinations making device 31. In addition to the wavelength switching function described above, the operation-end judging device 34 has a steady-state function which controls the plural-combinations making device 31, the second combination extracting device 32, and the first combination making device 34 to repeatedly execute the operations thereof.

Next, effects of the wavelength tunable light source 10 of this exemplary embodiment will be described by making comparisons with the wavelength tunable light source 100 that is shown in FIG. 16 and FIG. 17.

With the wavelength tunable light source 100 shown in FIG. 16 and FIG. 17, it is not possible to change both powers supplied to the heaters 122h and 123h to be in a sine wave form simultaneously, since it becomes unclear which of the supplied powers affect the amplitude of the photocurrent. Therefore, the supplied power for one of the heaters is fixed, the supplied power for the other heater is changed in a sine wave form, and the supplied power value with which the amplitude of the photocurrent becomes the minimum is obtained along with the photocurrent value of that time. Subsequently, the supplied power for one of the heaters is slightly changed and fixed, and the supplied power for the other heater is changed in a sine wave form in the same manner. This operation is repeated for a number of times to create a three-dimensional map which shows relations between the power supplied to the heaters 122h, 123h and the photocurrents. The supplied power values for the heaters 122h, 123h with which the photocurrent becomes the smallest are selected from that map. As described, the control method shown in FIG. 17 requires processing for changing the supplied powers comprehensively, so that it takes time to obtain the optimum supplied power values. Specifically, it is required to execute processing for changing the supplied powers for a large area of (x₂-x₁)×(y₂-y₁), where the supplied power for the heater 123h is the x-coordinate, the supplied power for the heater 122h is the y-coordinate, variable range of supplied power for the heater 123h is (x₂-x₁), and variable range of the supplied power for the heater 122h is (y₂-y₁).

In the meantime, with the exemplary embodiment, a plurality of combinations regarding the first combination of the values of each power supplied to the heaters 22h, 23h are made by changing at least one value of the supplied powers, the combination with which the sum of the optical powers detected at the light-receiving elements 21p - 23p becomes the minimum is taken as the second combination by controlling the heaters 22h, 23h according to the plurality of combinations and the first combination, and the values of each supplied power of the first combination is brought closer to the values of each supplied power of the second combination to make a new first combination. These operations are repeated. This means nothing other than predicting the position on the coordinates that may be of the optimum supplied power values and changing the supplied powers concentratedly around that area, provided that the supplied power for the heater 23h is the x-coordinate and the supplied power for the heater 22h is the y-axis. Therefore, it only requires smaller number of changes in the supplied powers compared to the control method shown in FIG. 17, so that the time spent for obtaining the optimum supplied power value can be shortened. Specifically, it only needs to change the supplied powers for only a small part of the area of (x₂-x₁) × (y₂-y₁), provided that the variable range of supplied power for the heater 23h is (x₂-x₁), and the variable range of the supplied power for the heater 22h is (y₂-y₁).

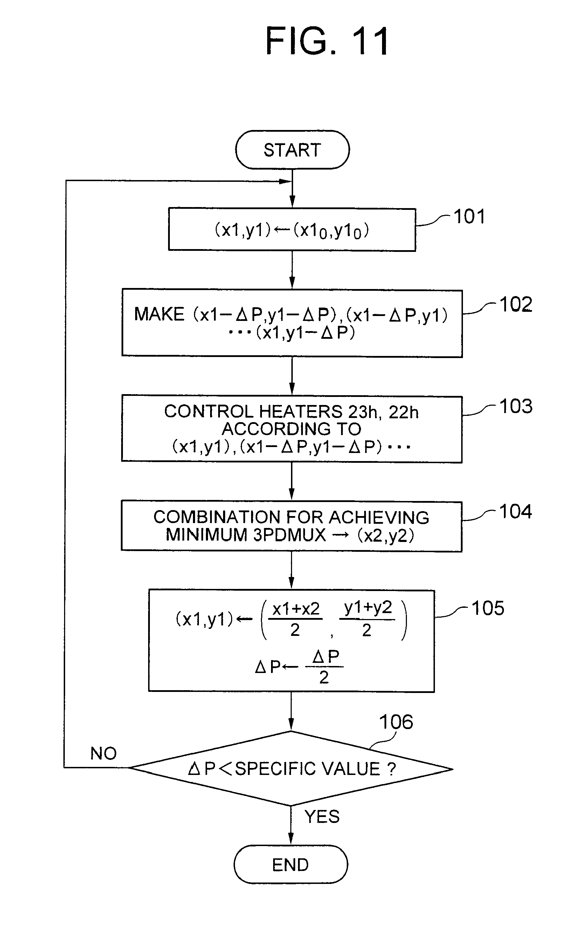

Next, specific examples of the operations executed by the control unit shown in FIG. 8 will be described by referring to FIG. 11 - FIG. 13. These operations can be achieved by a program that enables the micro computer 40 to function as each device of the control unit 18. FIG. 11 is a flowchart showing an example of a wavelength switching operation executed by the control unit shown in FIG. 8. Explanations will be provided hereinafter by referring to FIG. 1 and FIG. 8 - FIG. 11.

First, initial values (x1₀, y1₀) that are set in advance as the values for corresponding to the resonance wavelength of the multiple ring resonator 20 are inputted, and those are taken as the first combination (x1, y1) (step 101). Subsequently, as shown in FIG. 9, regarding the first combination (x1, y1) that is the combination of the values of each supplied power to the heaters 23h, 22h, eight kinds of combinations are made by increasing/decreasing the values by the amount of the power amplitude ΔP (step 102). The eight combinations are (x1-ΔP, y1-ΔP), (x1-ΔP, y1), (x1-ΔP, y1+ΔP), (x1, y1+ΔP), (x1+ΔP, y1+ΔP), (x1+ΔP, y1), (x1+ΔP, y1-ΔP), and (x1, y1-ΔP).

Then, the heaters 23h and 22h are controlled according to the eight kinds of combinations and the first combination (step 103). Here, the supplied power for the heaters 23h, 22h are fixed to the values of each combination to control the amount of electricity flown to the phase control area 17a so as to minimize the sum of the photocurrents at the light-receiving elements 21p - 23p. The combination with which the sum of the optical powers detected at the light-receiving elements 21p - 23p becomes the minimum is taken as the second combination(x2, y2) (step 104).

Subsequently, half values of the sum of the values of each supplied power of the second combination and the values of each supplied power of the first combination, "((x1+x2)/2, (yl+y2)/2)", are taken as a new first combination, and a half the value of the power amplitude ΔP, "ΔP/2", is taken as a new power amplitude (step 105).

Then, it is judged whether or not the new power amplitude has become a specific value or smaller (step 106). When the new power amplitude has become the specific value or smaller, it is judged to have reached a target wavelength. Thereby, the operation is ended. In the meantime, when the new power amplitude has not become the specific value or smaller, the operation returns to step 102 with a new first combination and a new power amplitude.

With this wavelength switching operation, the position on the coordinates that may be of the optimum supplied power values is predicted, and the supplied powers around that area are changed concentratedly. Therefore, the optimum supplied power values can be obtained efficiently in a short time. The number of combinations made in step 102 is not limited to eight kinds, but may be any numbers as long as there are a plurality of combinations. Further, a numerical value that divides ΔP in step 105 is not limited to "2", but may be any value as long as it is equal to "1" or more. Further, the value may not have to be constant at all times, but may change (for example, may decrease or increase gradually).

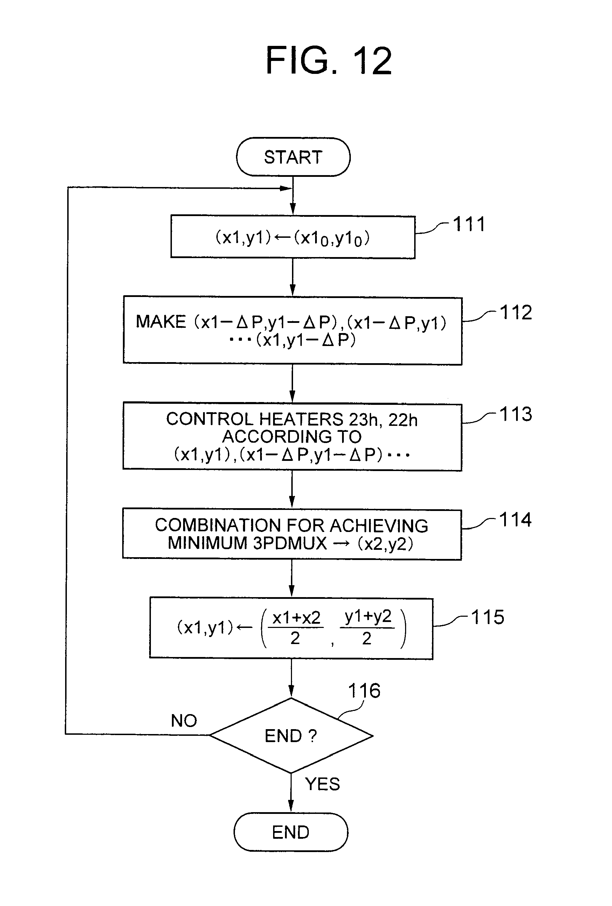

FIG. 12 is a flowchart showing an example of a steady-state operation performed by the control unit shown in FIG. 8. Explanations will be provided hereinafter by referring to FIG. 1 and FIG. 8 - FIG. 12.

First, initial values (x1₀, y1₀) that are the values corresponding to the resonance wavelength of the multiple ring resonator 20 obtained by the wavelength switching operation shown in FIG. 11 are inputted, and those are taken as the first combination (x1, y1) (step 111). Subsequently, as shown in FIG. 9, regarding the first combination (x1, y1) that is the combination of the values of each supplied power to the heaters 23h, 22h, eight kinds of combinations are made by increasing/decreasing the values by the amount of the power amplitude ΔP (step 112). The eight combinations are (x1-ΔP, y1-ΔP), (x1-ΔP, y1), (x1-ΔP, y1+ΔP) (x1, y1+ΔP), (x1+ΔP, y1+ΔP), (x1+ΔP, y1), (x1+ΔP, y1-ΔP), and (x1, y1-ΔP).

Then, the heaters 23h and 22h are controlled according to the eight kinds of combinations and the first combination (step 113). Here, the supplied power for the heaters 23h, 22h are fixed to the values of each combinations to control the amount of electricity flown to the phase control area 17a so as to minimize the sum of the photocurrents at the light-receiving elements 21p - 23p. The combination with which the sum of the optical powers detected at the light-receiving elements 21p - 23p becomes the minimum is taken as the second combination(x2, y2) (step 114).

Subsequently, half values of the sum of the values of each supplied power of the second combination and the values of each supplied power of the first combination, "((x1+x2)/2, (y1+y2)/2)", are taken as a new first combination, and the operation returns to step 111 (step 115). The above-described steps 112 - 115 are repeated. A following step may also be added.

The operations of steps 112 - 115 are repeatedly executed, and those operations are ended upon receiving an ending instruction (step 116).

With this steady-state operation, the position on the coordinates that may be of the optimum supplied power values is predicted, and the supplied powers around that area are changed concentratedly. Therefore, the optimum supplied power values can be obtained efficiently in a short time. Further, it is possible to correspond to chronological changes in the optimum value of the supplier powers by repeating steps 112 - 115 constantly during the operation of the wavelength tunable light source 10. The number of combinations made in step 112 is not limited to eight kinds, but may be any number as long as there are a plurality of combinations.

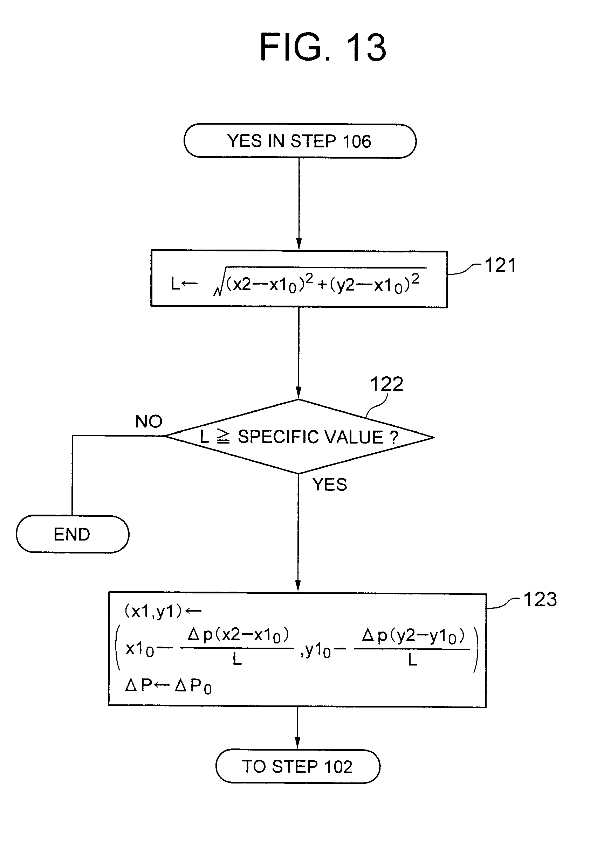

FIG. 13 is a flowchart showing an example of a re-convergence operation executed by the control unit shown in FIG. 8. Explanations will be provided hereinafter by referring to FIG. 1 and FIG. 8 - FIG. 13.

When it is "Yes" in step 106 of FIG. 11, a following re-convergence operation may be added. It is assumed here that the initial values of the first combination (x1, y1) are (x1₀, y1₀), and a power value smaller than the initial value ΔP₀ of the power amplitude ΔP is Δp. First, as shown in FIG. 10, a difference L = √{x2-x1₀}²+(y2-y1₀)²} between the values of each supplied power of the second combination and the initial values of each supplied power of the first combination is obtained (step 121). Then, it is judged whether or not "L" is a specific value or larger (step 122). When "L" is less than the specific value, it is judged as having converged to the channel of the target wavelength, and the operation is ended. In the meantime, when "L" is equal to the specific value or larger, it is judged as having converged to a channel of another wavelength, so that "(x1₀-ΔP{(x2-X1₀)/L}, y1₀-ΔP{(y2-y1₀)/L})" is taken as a new first combination, and the initial value of the power amplitude ΔP is taken as a new power amplitude (step 123). Then, the operation shifts to step 102 with the new first combination and the new power amplitude.

When the answer is "Yes" in step 122, it is judged as generating such an error of having converged to a wavelength channel that is different from a target wavelength. As a cause for such error, it can be considered that the initial values (x1₀, y1₀) in step 101 of Fig. 11 are too close to the final values of the second combination at the different wavelength channel. Thus, a point that is shifted from the initial values (x1₀, y1₀) in a direction away from the final values of the second combination is taken as the first combination, and the operations of step 102 and thereafter shown in FIG. 11 are executed. With this re-convergence operation, it is possible to converge to the target wavelength channel properly, even if it once converges to another wavelength channel that is different from the target wavelength.

The control method according to the present invention is nothing less or more than the operation of the wavelength tunable light source 10, and the control program according to the present invention is for enabling the micro computer 40 to function as each device of the control unit 18.

As an exemplary advantage according to the invention, the light-receiving elements are provided at the through ports, respectively, for obtaining the sum of the optical powers detected at the light-receiving elements so as to obtain the sum of the optical powers not optically but electrically, when controlling the plurality of light variable parts in such a manner that the sum of the optical powers outputted from the through ports of the plurality of resonators becomes the minimum. Therefore, it is possible to prevent deterioration in the detection accuracy of the optical powers caused due to interference fringes. As a result, the detection accuracy of the optical powers can be improved without increasing the size and the like of the device.

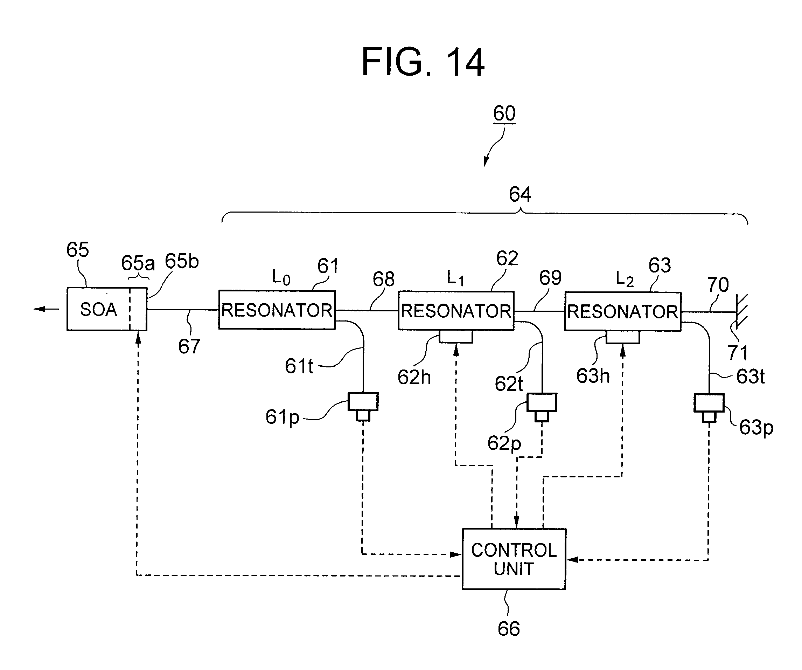

FIG. 14 is a block diagram showing a second exemplary embodiment of the wavelength tunable light source according to the present invention. Explanations will be provided hereinafter by referring to this drawing.

A wavelength tunable light source 60 according to this exemplary embodiment includes: a multiple resonator 64 including a plurality of coupled resonators 61, 62, 63 which have optical path lengths L₀, L₁, L₂ different from each other; light-receiving elements 61d, 62d, 63d as photosensor parts for detecting optical powers outputted from the resonators 61, 62, 63 via through ports 61t, 62t, 63t; light variable parts 62h, 63h which individually work on the resonators 62 and 63 to change the transmittance of the multiple resonator 64; an SOA 65 as a light input/output part which supplies light to the multiple resonator 64 and emits the light returned from the multiple resonator 64 to the outside; and a control unit 66 for controlling the light variable parts 62h and 63h according to the optical powers detected at the light-receiving elements 61d, 62d, and 63d. The light-receiving elements 61d, 62d, and 63d are provided at the through ports 61t, 62t, and 63t, respectively. The control unit 66 has a function of controlling the light variable parts 62h, 63h and a phase control area 65a such that the sum of the optical powers detected at the light-receiving elements 61d, 62d, and 63d becomes the minimum.

The light-receiving elements 61p, 62p, and 63p are photodiodes, for example, which output electric signals in accordance with the powers of the light irradiated to the light-receiving faces. The sum of the electric signals outputted from the light-receiving elements 61p, 62p, and 63p may be obtained in an analog way by an operational amplifier circuit or the like, or may be obtained in a digital way by an A/D converter and a microcomputer.

The resonators 61 - 63 are any of those selected from etalon filters, Mach-Zehnder interferometers, high-refractive index crystals, and the like, for example, which have different optical path lengths from each other. The resonators 61 - 63 are coupled to each other via waveguides 68 and 69. The ring resonator 64, in addition to the resonators 61 - 63, includes:
an input/output side waveguide 67 whose one end is connected to the resonator 61 and the other end is connected to the SOA 65; a reflection side waveguide 70 whose one end is connected to the ring resonator 63; and a high reflection film 71 provided to the other end of the reflection side waveguide 70. The SOA 65 has the phase control area 65a, and a light input/output end 65b is connected to the other end of the input/output side waveguide 67. The light variable parts 62h and 63h are the above-described heaters, piezoelectric elements, or the like for the etalon filters, the above-described filters or the like for the Mach-Zehnder interferometers, and mechanisms or the like that tilts polarized waves of the incident light for the high-refractive index crystals.

Except for the point that the resonators 61 - 63 such as the etalon filters are used instead of the ring resonators 21 - 23 of FIG. 1, the wavelength tunable light source 60 of this exemplary embodiment has almost the same structure as that of the wavelength tunable light source 10 shown in FIG. 1. Therefore, the wavelength tunable light source 60 of this exemplary embodiment operates in the same manner as that of the wavelength tunable light source 10 shown in FIG. 1, and provides the same functions and effects as those of the wavelength tunable light source 10 shown in FIG. 1.

FIG. 15 shows a first exemplary embodiment of an optical module according to the present invention, in which FIG. 15A is a plan view and FIG. 15B is a fragmentary side view. Explanations will be provided hereinafter by referring to those drawings. However, the same reference numerals are applied to the components that are the same as those of FIG. 1, and explanations thereof will be omitted.

An optical module 50 according to this exemplary embodiment includes: a wavelength tunable light source 10 shown in FIG. 1; the Peltier element 52 as a temperature regulating part for keeping the temperature of the wavelength tunable light source 10 except for the control unit 18; a case 51 for housing the Peltier element 52 and the wavelength tunable light source 10 except for the control unit 18; pins 57 as electricity conducting parts which supply electric powers to the wavelength tunable light source 10 and the Peltier element 52 from the outside the case 51, and inputs/outputs the electric signal; and an optical fiber 56 as a light conduction part for guiding the light emitted from the wavelength tunable light source 10 to the outside the case 51.

In the optical module 50, the wavelength tunable light source 10 of FIG. 1 except for the control unit 18 is housed within the case 51. However, this wavelength tunable light source 10 is illustrated schematically, and the structure thereof is slightly different from the structure shown in FIG. 1. In addition to the feature elements of the wavelength tunable light source 10 such as the SOA 17 and the PLC board 15, there are a pedestal 53, a micro lens 54, a light isolator 55, and the like provided inside the case 51. The optical fiber 56 is provided from the inside of the case 51 to the outside. Provided on the outside of the case 51 are the pins 57 that are electrically connected to the Peltier element 52, the SOA 17, the PLC board 15, and the like. The pedestal 53 is made with CuW, and it is provided on the Peltier element 52. The SOA 17, the PLC board 15, the micro lens 54, and the like are provided on the pedestal 53. The control unit 18 is connected to the pins 57. The control unit 18 is configured with the micro computer and its peripheral components, and it has a function of controlling the Peltier element 52 as well.

Next, operations of the optical module 50 will be described. First, the control unit 18 supplies control signals and the electric power to the SOA 17, the PLC board 15, the Peltier element 52, and the like via the pins 57. Thereby, the wavelength tunable control described above is executed, so that light of a desired wavelength is outputted to the SOA 17 → the micro lens 54 → the light isolator 55 → the optical fiber 56.

With this exemplary embodiment, the whole effects of the wavelength tunable light source 10 described above can be achieved. In addition, the exemplary embodiment can reduce the number of components, since the SOA 17 and the PLC board 15 are coupled directly (butt coupling). Thus, it is advantageous for reducing the size.

While the present invention has been described above by referring to each of the exemplary embodiments, it is to be understood that the present invention is not to be limited to those exemplary embodiments described above. Various changes and modifications occurred to those skilled in the art in the structures and the details of the present invention are possible. Further, it is to be understood that the present invention includes combinations of a part or the whole parts of the structures of each of the exemplary embodiments.

For example, the multiple ring resonator (multiple resonator) is not limited to contain three ring resonators (resonators), but may be configured by coupling two, or four or more ring resonators (resonators). Further, each of the ring resonators may be coupled directly only with a directional coupler. The light input/output part is not limited to the SOA, but may be the optical fiber amplifier and the like. The light variable parts are not limited to the heaters that change the wavelengths with heat, but may be those that change the wavelengths electrically or mechanically, for example. The number of the light variable parts is not limited to "2", but may be "3" or more. The sum of the optical powers detected at each light-receiving element may be obtained optically, and the optical power adding device may be omitted.

When the exemplary embodiments are built as a control program for enabling a computer to control the light variable parts that change the transmittance of the plurality of resonators, the control program is recorded to a recording medium. The program can be a target of business transactions, while it is being recorded to the recording medium for commercial use.

An example 1 describes a wavelength tunable light source means for changing a wavelength of light by using a multiple resonator including two or more coupled resonators with different optical path lengths from each other, comprising:
a single or more light variable means for changing transmittance of the resonators;
photosensor means for detecting each light outputted from the two or more resonators by each of the resonators as optical powers being converted into electric power values; and
a control means for adding the optical powers detected by the photosensor means by each of the resonators, and controlling changes in the transmittance by the light variable means such that sum of the added optical powers becomes minimum.

An example 2 describes the wavelength tunable light source means as described in the example 1, wherein:
the control means controls the light variable means by each of the optical powers outputted respectively from the photosensor means; and
the light variable means changes the transmittance of the resonators individually.

An example 3 describes the wavelength tunable light source means as described in the example 1, comprising three or more of the resonators and two or more of the light variable means, wherein
the control means controls one of the two or more light variable means to be used for fine adjustment and remainder to be used for coarse adjustment so as to use the transmittance of one of the resonators as a reference to change the transmittance of the remaining resonators.

An example 4 describes the wavelength tunable light source means as described in the example 3, wherein the control means executes a control to change a supplied power at an
x-coordinate and a supplied power at a y-coordinate concentratedly in an area at coordinates that may be of optimum supplied power values, provided that the x-coordinate is the supplied power for one of the light variable means and the y-coordinate is the supplied power for the other light variable means.

An example 5 describes the wavelength tunable light source means as described in the example 4, wherein the control means includes:
a plural-combinations making means for making a plurality of combinations by changing a value of at least one control input, regarding a first combination of values of each control input for the plurality of light variable means;
a second combination extracting means for controlling the plurality of light variable means according to the plurality of combinations and the first combination, and taking a combination with which the sum of the optical powers detected at the plurality of photosensor means becomes the minimum as a second combination; and
a first combination making means for bringing the values of each control input of the first combination closer to the values of each control input of the second combination to make a new first combination, and outputting the new first combination to the plural-combinations making means.

An example 6 describes the wavelength tunable light source means as described in the example 5, wherein:
three ring resonators are used as the resonators;
   the photosensor means detect light outputted from the three ring resonators as optical powers being converted into electric power values;
   two heaters are used as the light variable means;
   the plural-combinations making means has a function of making a plurality of combinations by changing at least one supplied power value, regarding the first combination of values of each supplied power for the heaters;
   the second combination extracting means has a function of controlling the plurality of heaters according to the plurality of combinations and the first combination, and taking a combination with which the sum of the optical powers detected individually at the photosensor means becomes the minimum as the second combination; and
   the first combination making means has a function of bringing the values of each supplied power value of the first combination closer to the values of each supplied power value of the second combination to make a new first combination, and outputting the new first combination to the plural-combinations making means.

An example 7 describes the wavelength tunable light source means as described in the example 6, wherein:
the plural-combinations making means has a function of making eight kinds of combinations (x1-ΔP, y1-ΔP), (x1-ΔP, y1), (x1-ΔP, y1+ΔP), (x1, y1+ΔP), (x1+ΔP, y1+ΔP), (x1+ΔP, y1), (x1+ΔP, y1-ΔP), and (x1, y1-ΔP), through increasing/decreasing the values in a first combination (x1, y1) that is a combination of values of powers supplied to each of the heaters by a power amplitude of ΔP;
   the second combination extracting means has a function of controlling the heaters according to the eight kinds of combinations and the first combination, and taking a combination with which the sum of the optical powers detected individually at the photosensor means becomes the minimum as a second combination(x2, y2); the first combination making means has a wavelength switching function which takes half values of the sum of the values of each supplied power of the second combination and the values of each supplied power of the first combination, "((x1+x2)/2, (y1+y2)/2)", as a new first combination, takes a half the value of the power amplitude ΔP, "ΔP/2", as a new power amplitude, and outputs the new first combination and the new power amplitude to the plural-combinations making means;
   a light variable means control means comprises an operation-end judging means having a wavelength switching function which ends operations of the plural-combinations making means, the second combination extracting means, and the first combination making means, when the new power amplitude becomes a specific value or smaller; and
   initial values of the first combination (x1, y1) are set in advance as the values corresponding to a resonance wavelength of the multiple ring resonator.

An example 8 describes the wavelength tunable light source means as described in the example 7, wherein the light conversion control means further comprises a re-convergence judging means which, after the operations of the plural-combinations making means, the second combination extracting means, and the first combination making means are ended by the operation-end judging means, takes "(x1₀-Δp{(x2-x1₀)/L}, y1₀-Δp{(y2-y1₀)/L})" as a new first combination, the initial value of the power amplitude ΔP as a new power amplitude, and outputs the new first combination and the new power amplitude to the plural-combinations making means, when a difference L = √{x2-x1₀}²+(y2-y1₀)²} between the values of each supplied power of the second combination and the initial values of each supplied power of the first combination becomes a specific value or larger provided that the initial value of the first combination (x1, y1) is (x1₀, y1₀) and a power value smaller than an initial value of the power amplitude ΔP is Δp.

An example 9 describes the wavelength tunable light source means as described in the example 7, wherein: the first combination making means comprises, in addition to the wavelength switching function, a steady-state function which takes half values of the sum of the values of each supplied power of the second combination and the values of each supplied power of the first combination, "((x1+x2)/2, (y1+y2)/2)", as a new first combination, and outputs the new first combination to the plural-combinations making means; and

the operation-end judging means comprises, in addition to the wavelength switching function, a steady-state function which controls the plural-combinations making means, the second combination extracting means, and the first combination making means to repeatedly execute the operations thereof.

An example 10 describes an optical module, comprising:
a wavelength tunable light source means for changing a wavelength of light by using a multiple resonator including two or more coupled resonators with different optical path lengths from each other;
a temperature regulating means for keeping a temperature of the wavelength tunable light source means except for a control means;
a casing means for housing the temperature regulating means and the wavelength tunable light source means except for the control means;
an electricity conducting means for supplying electric powers to the temperature regulating means and the wavelength tunable light source means except for the control means from butside of the casing means, and inputs/outputs an electric signal; and
a light conduction means for guiding light emitted from the wavelength tunable light source means to the outside the casing means, wherein
   the wavelength tunable light source means comprises:
   a single or more light variable means for changing transmittance of the resonators;
      photosensor means for detecting each light outputted from the two or more resonators by each of the resonators as optical powers being converted into electric power values; and
      the control means for adding the optical powers detected by the photosensor means by each of the resonators, and
   controlling changes in the transmittance by the light variable means such that sum of the added optical powers becomes minimum.

An example 11 describes a control method of a wavelength tunable light source means that changes a wavelength of light by using a multiple resonator including two or more coupled resonators with different optical path lengths from each other, the method comprising:
detecting each light outputted from the two or more resonators by each of the resonators as optical powers that are being converted into electric power values; and
adding the optical powers detected by each of the resonators, and changing transmittance of the resonators by a plurality of light variable means individually such that sum of the added optical powers becomes minimum.

An example 12 describes the control method of the wavelength tunable light source means as described in the example 11, which repeats operations of:
making a plurality of combinations by changing a value of at least one control input, regarding a first combination of values of each control input for the plurality of light variable means;
controlling the plurality of light variable means according to the plurality of combinations and the first combination, and taking a combination with which the sum of the optical powers detected for each of the resonator becomes the minimum as a second combination; and
bringing the values of each control input of the first combination closer to the values of each control input of the second combination to make a new first combination, and making the plurality of combinations to obtain a new first combination again.

An example 13 describes a control program for a wavelength tunable light source means that changes a wavelength of light by using a multiple resonator including two or more coupled resonators with different optical path lengths from each other, which enables a computer to execute a function of adding optical powers that are detected by converting light outputted respectively from the two or more resonators into electric power values, and changing transmittance of the resonators by a plurality of light variable means individually such that sum of the added optical powers becomes minimum.

An example 14 describes the control program for the wavelength tunable light source means as described in the example 13, which enables the computer to execute:
a function of making a plurality of combinations by changing a value of at least one control input, regarding a first combination of values of each control input for the plurality of light variable means;
a function of controlling the plurality of light variable means according to the plurality of combinations and the first combination, and taking a combination with which the sum of the optical powers detected at a plurality of photosensor means becomes the minimum as a second combination; and a function of bringing the values of each control input of the first combination closer to the values of each control input of the second combination to make a new first combination, and outputting the new first combination to the plural-combinations making means.

## Claims

1. A wavelength tunable light source means for changing a wavelength of light by using a multiple resonator including two or more coupled resonators with different optical path lengths from each other, comprising:
a single or more light variable means for changing transmittance of the resonators;
photosensor means for detecting each light outputted from the two or more resonators by each of the resonators as optical powers being converted into electric power values; and
a control means for adding the optical powers detected by the photosensor means by each of the resonators, and controlling changes in the transmittance by the light variable means such that sum of the added optical powers becomes minimum.

2. The wavelength tunable light source means as claimed in claim 1, wherein:
the control means controls the light variable means by each of the optical powers outputted respectively from the photosensor means; and
the light variable means changes the transmittance of the resonators individually.

3. The wavelength tunable light source means as claimed in claim 1, comprising three or more of the resonators and two or more of the light variable means, wherein the control means controls one of the two or more light variable means to be used for fine adjustment and remainder to be used for coarse adjustment so as to use the transmittance of one of the resonators as a reference to change the transmittance of the remaining resonators.

4. The wavelength tunable light source means as claimed in claim 3, wherein the control means executes a control to change a supplied power at an x-coordinate and a supplied power at a y-coordinate concentratedly in an area at coordinates that may be of optimum supplied power values, provided that the x-coordinate is the supplied power for one of the light variable means and the y-coordinate is the supplied power for the other light variable means.

5. The wavelength tunable light source means as claimed in claim 4, wherein the control means includes:
a plural-combinations making means for making a plurality of combinations by changing a value of at least one control input, regarding a first combination of values of each control input for the plurality of light variable means;
a second combination extracting means for controlling the plurality of light variable means according to the plurality of combinations and the first combination, and taking a combination with which the sum of the optical powers detected at the plurality of photosensor means becomes the minimum as a second combination; and
a first combination making means for bringing the values of each control input of the first combination closer to the values of each control input of the second combination to make a new first combination, and outputting the new first combination to the plural-combinations making means.

6. The wavelength tunable light source means as claimed in claim 5, wherein:
three ring resonators are used as the resonators;
the photosensor means detect light outputted from the three ring resonators as optical powers being converted into electric power values;
two heaters are used as the light variable means;
the plural-combinations making means has a function of making a plurality of combinations by changing at least one supplied power value, regarding the first combination of values of each supplied power for the heaters;
the second combination extracting means has a function of controlling the plurality of heaters according to the plurality of combinations and the first combination, and taking a combination with which the sum of the optical powers detected individually at the photosensor means becomes the minimum as the second combination; and
the first combination making means has a function of bringing the values of each supplied power value of the first combination closer to the values of each supplied power value of the second combination to make a new first combination, and outputting the new first combination to the plural-combinations making means.

7. The wavelength tunable light source means as claimed in claim 6, wherein:
the plural-combinations making means has a function of making eight kinds of combinations (x1-ΔP, y1-ΔP), (x1-ΔP, y1), (x1-ΔP, y1+ΔP), (x1, y1+ΔP), (x1+ΔP, y1+ΔP), (x1+ΔP, y1), (x1+ΔP, y1-ΔP), and (x1, y1-ΔP), through increasing/decreasing the values in a first combination (x1, y1) that is a combination of values of powers supplied to each of the heaters by a power amplitude of ΔP;
the second combination extracting means has a function of controlling the heaters according to the eight kinds of combinations and the first combination, and taking a combination with which the sum of the optical powers detected individually at the photosensor means becomes the minimum as a second combination(x2, y2); the first combination making means has a wavelength switching function which takes half values of the sum of the values of each supplied power of the second combination and the values of each supplied power of the first combination, "((xl+x2)/2, (y1+y2)/2)", as a new first combination, takes a half the value of the power amplitude ΔP, "ΔP/2", as a new power amplitude, and outputs the new first combination and the new power amplitude to the plural-combinations making means;
a light variable means control means comprises an operation-end judging means having a wavelength switching function which ends operations of the plural-combinations making means, the second combination extracting means, and the first combination making means, when the new power amplitude becomes a specific value or smaller; and
initial values of the first combination (x1, y1) are set in advance as the values corresponding to a resonance wavelength of the multiple ring resonator.

8. The wavelength tunable light source means as claimed in claim 7, wherein the light conversion control means further comprises a re-convergence judging means which, after the operations of the plural-combinations making means, the second combination extracting means, and the first combination making means are ended by the operation-end judging means, takes "(x1₀-Δp{(x2-x1₀)/L}, y1₀-Δp{(y2-y1₀)/L})" as a new first combination, the initial value of the power amplitude ΔP as a new power amplitude, and outputs the new first combination and the new power amplitude to the plural-combinations making means, when a difference L = √{x2-x1₀}²+(y2-y1₀)²} between the values of each supplied power of the second combination and the initial values of each supplied power of the first combination becomes a specific value or larger provided that the initial value of the first combination (x1 y1 is (x1₀, y1₀) and a power value smaller than an initial value of the power amplitude ΔP is Δp.

9. The wavelength tunable light source means as claimed in claim 7, wherein:
the first combination making means comprises, in addition to the wavelength switching function, a steady-state function which takes half values of the sum of the values of each supplied power of the second combination and the values of each supplied power of the first combination, "((x1+x2)/2, (y1+y2)/2)", as a new first combination, and outputs the new first combination to the plural-combinations making means; and
the operation-end judging means comprises, in addition to the wavelength switching function, a steady-state function which controls the plural-combinations making means, the second combination extracting means, and the first combination making means to repeatedly execute the operations thereof.

10. An optical module, comprising:
a wavelength tunable light source means for changing a wavelength of light by using a multiple resonator including two or more coupled resonators with different optical path lengths from each other;
a temperature regulating means for keeping a temperature of the wavelength tunable light source means except for a control means;
a casing means for housing the temperature regulating means and the wavelength tunable light source means except for the control means;
an electricity conducting means for supplying electric powers to the temperature regulating means and the wavelength tunable light source means except for the control means from outside of the casing means, and inputs/outputs an electric signal; and
a light conduction means for guiding light emitted from the wavelength tunable light source means to the outside the casing means, wherein
the wavelength tunable light source means comprises: a single or more light variable means for changing transmittance of the resonators;
photosensor means for detecting each light outputted from the two or more resonators by each of the resonators as optical powers being converted into electric power values; and
the control means for adding the optical powers detected by the photosensor means by each of the resonators, and controlling changes in the transmittance by the light variable means such that sum of the added optical powers becomes minimum.

11. A control method of a wavelength tunable light source means that changes a wavelength of light by using a multiple resonator including two or more coupled resonators with different optical path lengths from each other, the method comprising:
detecting each light outputted from the two or more resonators by each of the resonators as optical powers that are being converted into electric power values; and
adding the optical powers detected by each of the resonators, and changing transmittance of the resonators by a plurality of light variable means individually such that sum of the added optical powers becomes minimum.

12. The control method of the wavelength tunable light source means as claimed in claim 11, which repeats operations of:
making a plurality of combinations by changing a value of at least one control input, regarding a first combination of values of each control input for the plurality of light variable means;
controlling the plurality of light variable means according to the plurality of combinations and the first combination, and taking a combination with which the sum of the optical powers detected for each of the resonator becomes the minimum as a second combination; and
bringing the values of each control input of the first combination closer to the values of each control input of the second combination to make a new first combination, and making the plurality of combinations to obtain a new first combination again.

13. A control program for a wavelength tunable light source means that changes a wavelength of light by using a multiple resonator including two or more coupled resonators with different optical path lengths from each other, which enables a computer to execute a function of adding optical powers that are detected by converting light outputted respectively from the two or more resonators into electric power values, and changing transmittance of the resonators by a plurality of light variable means individually such that sum of the added optical powers becomes minimum.

14. The control program for the wavelength tunable light source means as claimed in claim 13, which enables the computer to execute:
a function of making a plurality of combinations by changing a value of at least one control input, regarding a first combination of values of each control input for the plurality of light variable means;
a function of controlling the plurality of light variable means according to the plurality of combinations and the first combination, and taking a combination with which the sum of the optical powers detected at a plurality of photosensor means becomes the minimum as a second combination; and
a function of bringing the values of each control input of the first combination closer to the values of each control input of the second combination to make a new first combination, and outputting the new first combination to the plural-combinations making means.
